# EUROPEAN PATENT APPLICATION

(11) **EP 2 608 643 A1**
(43) Date of publication of application: **26.06.2013**
(21) Application number: 11250939.3
(22) Date of filing: 23.12.2011
(51) Int. Cl.: H05K 3/46, H05K 1/09, H05K 1/02, H01B 7/08, H01P 3/04

(54) **Cable**

(71) Applicant: British Telecommunications public limited company, London EC1A 7AJ (GB)
(72) Inventor: The designation of the inventor has not yet been filed
(74) Representative: Brinck, Coreena Fiona Anne

(57) **Abstract**

The present invention discloses a new and inventive cable structure and a method for manufacturing such a cable. The cable (100) has a planar form and comprises one or more pairs of carbon nanotube wires (120). The cable has an adhesive surface such that it can be readily installed (and subsequently repositioned) within a domestic, or commercial, premises. Such a cable would enable in premises transmission of very high bit-rate data without the disadvantages associated with structured cables and wiring.

## Description

The present invention relates to a cable and in particular to a cable for use in transmitting data at high bit rates within domestic or commercial premises.

Asymmetric digital subscriber line (ADSL) systems enable data to be transmitted over a pair of metallic twisted pair (usually copper) wires to customer premises. It is thought that the realistic maximum transmission performance that is likely to be obtained with modern variants of ADSL is a download data rate of 24 Mbps and an upload speed of about 3 Mbps at the expected nominal distance of a customer premises from an exchange or distribution point in a telecommunications network. Such data rates are dependent on the length of the metallic twisted pair from the customer premises to the telephone exchange and thus many customers will receive services at significantly lower data rates.

To improve data rates optical fibre has been installed into the access network. The greatest data rates are likely to be provided using fibre to the premises (FTTP) networks, such as passive optical networks (PONs) but there is a significant cost involved in providing fibre to customer premises. Fibre to the cabinet (FTTCab) networks are known to provide an attractive solution to providing customers with high data rate services without requiring as much investment as FTTP networks. Typically in FTTCab networks, very high bit-rate digital subscriber line (VDSL) systems are used to provide data rates of 40 Mbps and higher, for both upload and download on the metallic twisted pair cables. It is believed that improvements to VDSL systems may provide data rates in excess of 100 Mbps. FTTP networks can provide almost unlimited bandwidth to customers and it is likely that commercial considerations rather than technical issues that will limit that data rates that will be supplied to customers.

The data transmitted to customers will be received at a network termination point and then must be demodulated by an appropriate modem before being sent to a router and then onwards to data consuming (and data producing) terminals such as computers, game consoles, set top boxes etc. WiFi connections are in theory capable of data rates of up to 150Mbps, but in real life conditions it can be difficult to obtain these data rates on a consistent basis. Microwave ovens, and other devices, can cause radio interference in the 2.4GHz range, walls and other structures can attenuate radio signals, WiFi signals from neighbours may interfere with the signal, etc. Whilst it is possible to support Gigabit Ethernet using Category 5 grade data cable, domestic customers are not always willing to have such cables installed within their homes to connect the router to the terminals. Furthermore, installing such cabling increases the time required to provide super-fast broadband services to customers and thus increases the cost of such service provision.

According to a first aspect of the present invention there is provided a cable for data transmission comprising: a first planar substrate; one or more pairs of electrical conductors received on the first planar substrate, wherein the electrical conductors comprise substantially exclusively carbon; and an adhesive surface such that, in use, the cable can be affixed to a surface. Preferably the carbon electrical conductors comprise carbon nanotube wires or wires formed from graphene.

The cable may further comprise a first deposited layer, the first deposited layer being deposited on the planar surface, wherein the first deposited layer affixes the one or more pairs of carbon electrical conductors to the first planar substrate.

The first deposited layer may comprise the adhesive surface of the cable. Alternatively, the cable may further comprise a second deposited layer, the second deposited layer being deposited on the first deposited layer such that the second deposited layer comprises the adhesive surface of the cable. Preferably the cable further comprises a second planar substrate, the second planar substrate being applied to the adhesive surface of the cable.

The carbon electrical conductors which comprise each of the one or more pairs of carbon electrical conductors may be arranged in parallel or alternatively they may be twisted around each other. The one or more pairs of carbon electrical conductors may be encapsulated in within a matrix.

According to a second aspect of the present invention there is provided a method of manufacturing a cable for data transmission, the method comprising the steps of: a) affixing one or more pairs of carbon electrical conductors to a first planar substrate; b) processing the cable such that it has an adhesive surface. The method may comprise the further step of: c) depositing a first layer on the first planar substrate so as to affix the one or more pairs of carbon electrical conductors to the first planar substrate, step c) being performed prior to step a).

The first deposited layer may provide the adhesive surface of the cable. Alternatively, the method may comprise the further step of: d) depositing a second layer on the first deposited layer wherein the second deposited layer provides the adhesive surface of the cable. The method may also comprise the further step of: e) applying a second planar substrate to the adhesive surface of the cable.

The method may comprise the yet further step of: f) encapsulating the one or more pairs of carbon electrical conductors within a matrix, wherein step f) is performed before step a) is performed.

The method may comprise the yet further step of: g) twisting the carbon electrical conductors which comprise each of the one or more pairs of carbon electrical conductors around each other, wherein step g) is performed before step a).

Embodiments of the present invention will now be described, by way of example only, with reference to the accompanying drawings in which:
Figure 1 shows a schematic depiction of a cable according to the present invention;
Figure 2 shows a schematic depiction of a cable according to an alternative embodiment of the present invention;
Figure 3 shows a schematic depiction of a process by which a cable according to the present invention can be made;
Figure 4a shows a schematic depiction of a cross-section of a first exemplary embodiment of the present invention;
Figure 5 shows a schematic depiction of a cross-section of an alternative to the first exemplary embodiment shown in Figure 4;
Figure 6 shows a schematic depiction of a cross-section of a second exemplary embodiment of the present invention; and
Figure 7 shows a schematic depiction of a cross-section of an alternative to the second exemplary embodiment shown in Figure 6.

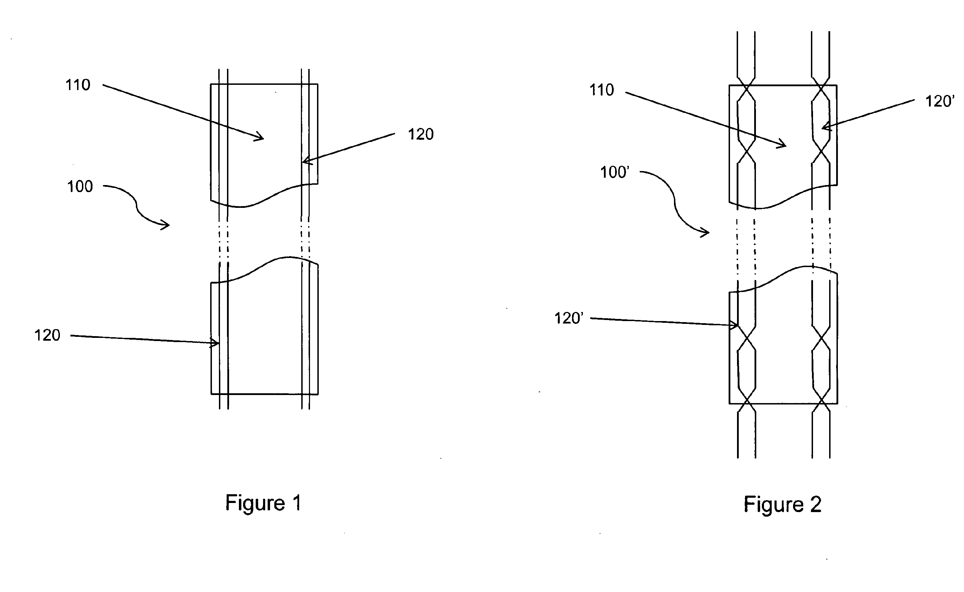

Figure 1 shows a schematic depiction of a cable 100 according to the present invention. The cable 100 comprises a first planar substrate 110 on which is received one or more pairs of carbon nanotube (CNT) wires 120. The one or more pairs of CNT wires 120 are arranged in a parallel manner. Figure 2 shows a schematic depiction of a cable 100' according to an alternative embodiment of the present invention in which each of the one or more pairs of CNT wires 120' are twisted together before they are received on the substrate. The first planar substrate 110 comprises an adhesive surface such that the cable can be fixed to a surface such as a wall, skirting board, floor, ceiling, etc. It will be understood that a second planar substrate 130 may be applied to the adhesive surface of the first planar substrate during the manufacturing process. This second planar substrate 130 can then be removed prior to installation.

Carbon nanotubes are an allotrope of carbon and they have a substantially cylindrical form. It is known to form wires from CNTs to take advantage of the electrical characteristics of CNTs such that electrical currents can be passed down the wires. See, for example, US 7,993,620, W02004/043858 and Zhao et al "Iodine doped carbon nanotube cables exceeding specific electrical conductivity of metals", Scientific Reports, |1:83| DOI: 10.1038/srep00083.

It has been demonstrated that carbon nanotubes can be fabricated in large quantities and with specific diameters and chirality that means that they have the properties of metallic conductors. It is thought that significant advantages in electrical and physical characteristics can be realised for wires manufactured from such CNTs. For example, it is theoretically predicted that such CNT wires will have lower resistivity than copper or silver conductors and that they will not be subject to the skin effect that is present in copper conductors, which leads to a decreased performance as the frequency of an AC current passed through them increases. In addition it has been demonstrated that CNTs can be used for data transmission. Physically, CNT wires have been demonstrated to be highly flexible and extremely strong and therefore suited to fabrication into very fine but robust structures.

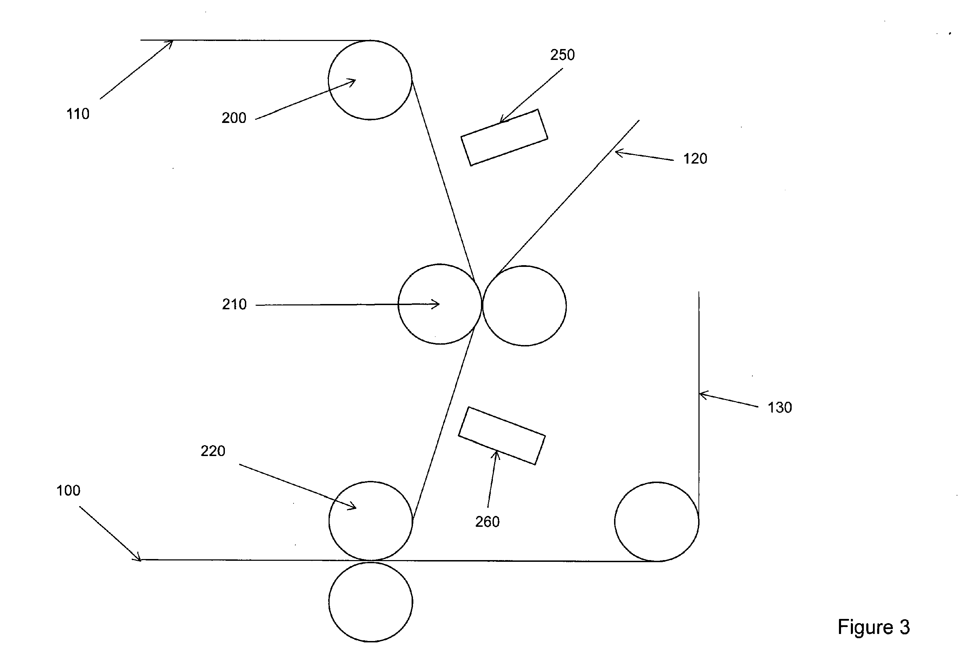

Figure 3 shows a schematic depiction of a process by which a cable according to the present invention can be made. The first planar substrate 110 is fed over a first roller 200 and a first melt is applied to the first substrate and then cured (or partially cured) using first applicator 250. The CNT wires 120 are then applied to the surface of the first substrate at a second roller 210. A second melt is then applied to the first substrate 110 and the CNT wires 120 and then cured (or partially cured) using second applicator 260. Finally, the second planar substrate 130 is applied to the first substrate and the CNT wires at third roller 220 to form the cable 100. The first melt adheres the CNT wires to the first planar substrate. When the second planar substrate 130 is removed from the cable the adhesive qualities of the second melt allows the cable to be affixed during cable installation, for example to a wall or skirting board. Preferably the adhesive qualities of the second melt allow the cable to be removed and then reattached to a surface. The first and second melts may be heat-curable or may be cured by the application of UV-radiation.

The CNT wires may be applied as parallel straight wires. Alternatively, the cable may comprise twisted pairs of CNT wires: these twisted pairs may be formed as the wires are applied to the first planar substrate or alternatively the pairs may be pre-twisted prior to the manufacture of the cable. The cable may comprise one or more pairs of CNT wires. To provide compatibility with existing equipment a cable preferably comprises two pairs of CNT wires (to provide a physical analogue of Cat 5 grade data cable) or four pairs of CNT wires (to provide a physical analogue of Cat 6 grade data cable). The CNT wires are preferably colour coded to allow them to be terminated and connectorised in a controlled and repeatable manner. The CNT wires may be formed into a single package before being applied to the first planar substrate, for example in a manner similar to those used to create optical fibre ribbons or the optical fibre bundles described in EP-B-521 710. The second planar substrate protects the adhesive surface until it is to be used in securing the cable. Printed indicia may be provided on the external surface of the planar substrates to differentiate the first planar substrate from the second planar substrate. This allows an installer to remove the second planar substrate so as to expose the adhesive surface of the second melt.

It will be understood that the process described above with reference to Figure 3 may be varied in a number of different ways. More than two layers of material may be applied to the planar substrate and/or the CNT wires, with one or more of the layers providing physical packaging and/or protection and one or more of the layers providing adhesive properties. Furthermore, the first and second melts may comprise planar layers of material that are attached to the first planar substrate by the application of pressure to the cable, for example by one or more mechanical rollers. The first planar substrate may be provided already coated with the first melt, which may be softened by the application of heat (or by some other form of preparation) and the CNT wires applied thereon. It will be understood that the first and second melts may comprise a combination of materials or that they may each comprise two or more layers of materials.

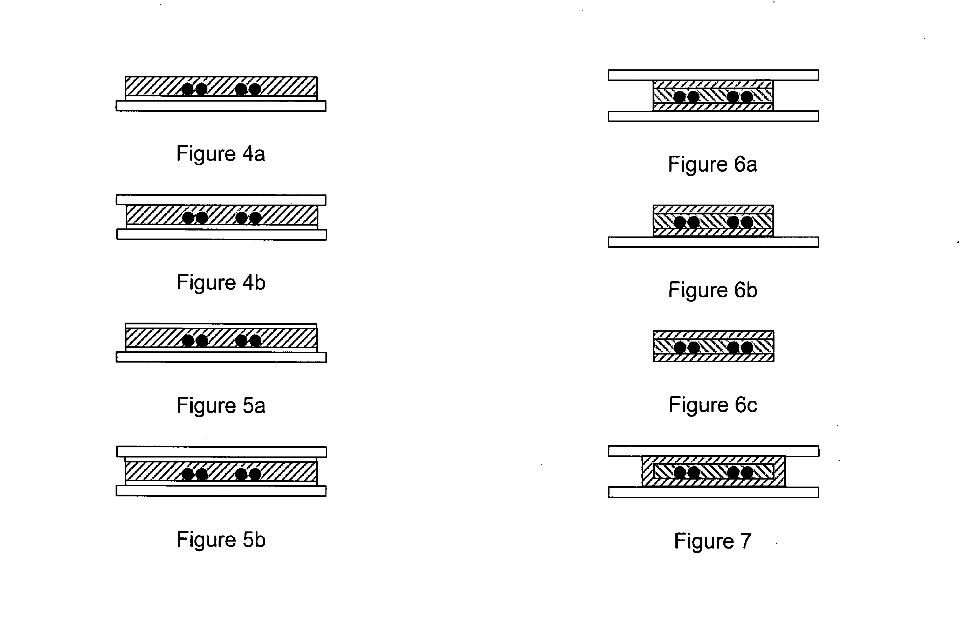

Figure 4a shows a schematic depiction of a cross-section of a first exemplary embodiment of the present invention. Cable 400 comprises first planar substrate 405, first deposited layer 410, which secures the CNT wires 415, and second deposited layer 420, which encapsulates the CNT wires and provides an adhesive upper surface. Figure 4b shows a schematic depiction of the cable of Figure 4a in which a second planar substrate 425 has been applied to the upper surface of the second deposited layer 420. To install the cable, the second planar substrate is removed from the cable and the adhesive upper surface of the second deposited layer 420 is used to affix the cable.

Figure 5a shows a schematic depiction of a cross-section of an alternative to the first exemplary embodiment of the present invention described above with reference to Figure 4. Cable 400' comprises first planar substrate 405, first deposited layer 410, which secures the CNT wires 415, and second deposited layer 420, which encapsulates the CNT wires. A third deposited layer 430 is deposited onto the second deposited layer and the adhesive upper surface of the third deposited layer 430 is used to affix the cable. Figure 5b Figure 4b shows a schematic depiction of the cable of Figure 4b in which a second planar substrate 425 has been applied to the upper surface of the third deposited layer 430.

Figure 6a shows a schematic depiction of a cross-section of a second exemplary embodiment of the present invention. Cable 500 comprises a first planar substrate 505, a plurality of CNT wires 515 encapsulated within a protective matrix 520, a first deposited layer 510, formed in between the first planar substrate and the protective matrix 520, a second planar substrate 530 and a second deposited layer 525, formed in between the second planar substrate and the protective matrix. Figure 6b shows the cable of Figure 6a after the second planar substrate 530 has been removed to expose the adhesive surface of the second deposited layer 525, such that the cable can be affixed to a surface. Figure 6c shows the cable of Figures 6a and 6b after the first planar substrate has been removed. The exposed surface of the first deposited layer may have adhesive qualities such that the cable can be affixed using either the first or the second deposited layer. Alternatively, the first deposited layer may not be adhesive. By removing both the first and second substrates the cable can be made to have a width which is easy to handle during installation yet in its installed state is narrower and thus less visually intrusive.

Figure 7 shows a schematic depiction of a cross-section of an alternative to the second exemplary embodiment of the present invention. Cable 500' comprises a first planar substrate 505, a plurality of CNT wires 515 encapsulated within a protective matrix 520 and a second planar substrate 530. A first deposited layer 540 encapsulates the protective matrix 520 such that it is formed in between the first planar substrate and the protective matrix and between the second planar substrate and the protective matrix.

It will be understood that further variants of the cable designs shown in Figures 4 to 7 will still fall within the scope of the present invention. The first and second planar substrates may be coloured, or otherwise decorated, so that they can distinguished from each other. The materials used to form the deposited layer(s), and/or a protective matrix for the CNT wires, may be transparent and/or have a matt finish so that an installed cable is as visually unobtrusive as possible.

During manufacture, the cable 100 will be made in long lengths. It is likely that the length of cable being manufactured will be limited by the length of CNT wire that can be produced. The cable may be provided in pre-determined lengths with suitable connectors affixed to each end. Alternatively, the cable may be provided on a spool and suitable connectors and tools may be provided so that the cable can be cut to size prior to the fitting of the connectors. Before terminating the cable the CNT wires may be exposed either mechanically (by removing the tape accurately with a tool) or by dipping the ends of the tape in a solvent that dissolves the tape (and any encapsulating material) but not the CNT wires. Alternatively the cable may be supplied to the user with a length of the CNT wire exposed at each end of the tape. The termination of the CNTs may be achieved by using a conventional known technique such as, for example, soldering, conductive paint or mechanical crimping. The termination may be made to metallic pins which can then be crimped, soldered or otherwise connected into a joint or a plug. Alternatively, the termination may be made directly into a jack plug.

Another known allotrope of carbon is graphene. It is known to spin graphene oxide flakes into fibres several metres in length (see Z Xu & C Gao, 'Graphene chiral liquid crystals and macroscopic assembled fibres' Nature Communications 2, 571 (2011)). These graphene fibres are electrically conductive and could be used in place of CNT wires in cables according to the present invention.

In summary, the present invention discloses a new and inventive cable structure and a method for manufacturing such a cable. The cable has a planar form and comprises one or more pairs of carbon nanotube wires. The cable has an adhesive surface such that it can be readily installed (and subsequently repositioned) within a domestic, or commercial, premises. Such a cable would enable in premises transmission of very bit-rate data without the disadvantages associated with structured cables and wiring.

## Claims

1. A cable for data transmission comprising:
a first planar substrate;
one or more pairs of electrical conductors received on the first planar substrate, wherein the electrical conductors comprise substantially exclusively carbon; and
an adhesive surface such that, in use, the cable can be affixed to a surface.

2. A cable for data transmission according to Claim 1, wherein the cable further comprises a first deposited layer, the first deposited layer being deposited on the planar surface, wherein the first deposited layer affixes the one or more pairs of carbon electrical conductors to the first planar substrate.

3. A cable for data transmission according to Claim 1 or Claim 2, wherein the first deposited layer comprises the adhesive surface of the cable.

4. A cable for data transmission according to Claim 2, wherein the cable further comprises a second deposited layer, the second deposited layer being deposited on the first deposited layer such that the second deposited layer comprises the adhesive surface of the cable.

5. A cable for data transmission according to any preceding Claim, wherein the cable further comprises a second planar substrate, the second planar substrate being applied to the adhesive surface of the cable.

6. A cable for data transmission according to any preceding Claim wherein the carbon electrical conductors which comprise each of the one or more pairs of carbon electrical conductors are arranged in parallel.

7. A cable for data transmission according to any preceding Claim wherein the carbon electrical conductors which comprise each of the one or more pairs of carbon electrical conductors are twisted around each other.

8. A cable for data transmission according to any preceding Claim wherein the one or more pairs of carbon electrical conductors are encapsulated in within a matrix.

9. A method of manufacturing a cable for data transmission, the method comprising the steps of:
a) affixing one or more pairs of carbon electrical conductors to a first planar substrate;
b) processing the cable such that it has an adhesive surface.

10. A method according to Claim 9, comprising the further step of:
c) depositing a first layer on the first planar substrate so as to affix the one or more pairs of carbon electrical conductors to the first planar substrate, step c) being performed prior to step a).

11. A method according to Claim 10, wherein the first deposited layer provides the adhesive surface of the cable.

12. A method according to Claim 10, wherein the method comprises the further step of:
d) depositing a second layer on the first deposited layer wherein the second deposited layer provides the adhesive surface of the cable.

13. A method according to any of Claims 9 to 12, wherein the method comprises the further step of:
e) applying a second planar substrate to the adhesive surface of the cable.

14. A method according to any of Claims 9 to 13, wherein the method comprises the further step of:
f) encapsulating the one or more pairs of carbon electrical conductors within a matrix, wherein step f) is performed before step a) is performed.

15. A method according to any of Claims 9 to 14, wherein the method comprises the further step of:
g) twisting the carbon electrical conductors which comprise each of the one or more pairs of carbon electrical conductors around each other, wherein step g) is performed before step a).
